Europäisches Patentamt

(19) European Patent Office

Office européen des brevets

(11) Publication number: **0 313 574 B1**

# EUROPEAN PATENT SPECIFICATION

(45) Date of publication of patent specification: 24.03.93

(51) Int. Cl.5: **B32B 27/16**, G01F 15/14, H01C 1/028, H01C 1/032, H01C 1/034, H01C 1/036, H05K 7/12

(21) Application number: 87904775.1

(22) Date of filing: 02.07.87

(86) International application number:
PCT/US87/01593

(87) International publication number:
WO 88/00135 (14.01.88 88/02)

(54) **POTTED ELECTRICAL/MECHANICAL DEVICES, AND DUAL CURE POTTING METHOD.**

(30) Priority: 07.07.86 US 882670

(43) Date of publication of application:
03.05.89 Bulletin 89/18

(45) Publication of the grant of the patent:
24.03.93 Bulletin 93/12

(84) Designated Contracting States:
DE FR GB

(56) References cited:
US-A- 2 683 767      US-A- 3 383 565
US-A- 3 622 419      US-A- 3 670 091
US-A- 3 699 200      US-A- 4 025 407
US-A- 4 073 835      US-A- 4 239 077
US-A- 4 330 929      US-A- 4 427 478
US-A- 4 479 990      US-A- 4 540 533
US-A- 4 552 604      US-A- 4 607 469

(73) Proprietor: **LOCTITE CORPORATION**
**705 North Mountain Road**
**Newington, Connecticut 06111(US)**

(72) Inventor: **DRAIN, Kieran, Francis**
**2194 Belle Vernon Drive**
**Rochester Hills, Michigan 48309(US)**
Inventor: **NATIVI, Larry, Armand**
**245 Annes Court**
**Rocky Hill, CT 06067(US)**

(74) Representative: **Marchant, James Ian**
**Elkington and Fife Prospect House 8 Pembroke Road**
**Sevenoaks, Kent TN13 1XR (GB)**

EP 0 313 574 B1

## Description

Technical Field

This invention relates to a method of potting electrical/mechanical devices, including a mechanism in a housing, by a cured resinous mass.

Background Art

In the manufacture of electrical/mechanical devices wherein a mechanism is disposed in a housing and potted with a cured mass of a resinous composition to provide a barrier between the mechanism and the external environment of the device, a number of curable compositions have been employed.

For example, Japanese patent application 57/134,923 discloses the manufacture of an electrolytic capacitor in which the capacitor element is positioned in an aluminum case and sealed with rubber prior to potting of the assembly with an epoxy or phenolic resin.

West German Offenlegungsschrift 2,649,070 teaches the encapsulation of polystyrene capacitors with a thermosetting epoxy in a mold at elevated temperature.

Thermosetting epoxy resins have come into broad usage in such potting applications due to their favorable properties, including high strength, hardness, solvent resistance, good adhesion to conventionally employed housing materials, thermal stability, gas impermeability, and ready curability by a variety of mechanisms and numerous curatives over a wide range of elevated temperature cure conditions.

Despite their significant advantages, however, thermosetting epoxy resins have associated disadvantages which have limited their use, or otherwise rendered their employment in the aforementioned potting applications difficult in the context of commercial high volume manufacturing operations.

A primary disadvantage of thermosetting epoxy resins in the potting of electrical/mechanical assemblies is that their viscosities decrease with increasing temperature under curing conditions until the onset of gellation is reached.

Thus, as the resinous mass dispensed into the housing of the device is subjected to elevated temperature, e.g., on the order of 65.6 - 204.4°C (150-400 °F), as in a cure oven, the viscosity of the epoxy resin progressively decrease. The positional stability of the resinous mass then is lost and it migrates or "runs" within the housing.

Such migratory behavior is deleterious due to its tendency to foul the mechanism in the housing. When the mechanism is mechanical or electromechanical in character, and thus includes moving parts, the fouling may interfere with or prevent the proper operation of the mechanism, rendering it useless for its intended purpose. When the mechanism is electrical in character, the fouling may change the conductivity, capacitance, resistance or other critical characteristics of the mechanism's components, ruining the device and requiring its rejection in the manufacturing operation.

Another significant disadvantage of the use of thermosetting epoxy resins in the potting of electrical/mechanical devices is associated with air or other ambient gas which is trapped around the mechanism when the resin is dispensed into the housing, particularly when the mechanism contains voids from which the ambient gas is not readily displaced when the liquid resin is introduced.

The trapped gas in the housing during the curing of the epoxy resin then may bubble through the curing mass, particularly since its viscosity is reduced at this stage, and produce gas channeling void formation in the finally cured composition mass. Frequently, this gas bubbling effect is extensive enough to create continuous leak path channels in the finally cured mass, with the result that the intended barrier function of the cured mass is defeated.

The gas bubbling effect is also present when ambient cure epoxy resins are employed, although to a lesser extent.

In some electrical/mechanical devices, the mechanism is interiorly disposed in the housing and the housing is provided with an opening through which a structural element is inserted and joined to the interior mechanism after the latter has been potted and the resinous mass fully cured. An example is a trimming potentiometer, wherein the lead screw or gear shaft is inserted into the housing to engage a wiper assembly whereby input voltage to the device may be divided as a function of the mechanical input.

In such devices the housing opening usefully serves as a "blow hole" accomodating the release of gas during the curing of the potting mass. The opening, however, also provides a flow path which may aid the migratory fouling of the interior mechanism as well migratory occlusion of the opening itself.

Relative to the resin compositions used in the present invention which overcome the aforementioned problems, relevant art includes US-A-4,412,048; Australian Patent Application 53,233/79; US-A-4,479,990;

EP 0 313 574 B1

US-A-4,239,077; US-A-4,025,407; US-A-4,552,604; US-A-4,427,478; Euorpean Patent Application 99,856; and Japanese Patent Application 60/84,715, disclosing acrylic/epoxy resin compositions which are sequentially UV and thermally cured. Other related art includes US-A-4,444,806 (co-heat cured acrylic/epoxy compositions); US-A-4,548,895 (composition containing 1,2-epoxy compounds and acrylates which are first thermal cured, then photocured by actinic radiation exposure); and US-A-4,288,527 and 4,352,723 (pinacol-containing acrylate compositions optionally with a copolymerizable monomer or reactive diluent, which "are cured by both ultraviolet radiation and heat, in either order or simultaneously to form solid products suitable for use as...sealants").

It is an objective of the present invention to provide a method of potting an electrical/mechanical device of the type containing a mechanism in a housing with a resinous composition avoiding the migratory fouling/occlusion and gas channelling void formation problems of previously used potting compounds.

The present invention relates to a method of potting a device including a mechanism in a housing, characterized in that it comprises:

(i) providing in the housing a self-leveling liquid composition comprising an actinic radiation curable first resin component and an ambient temperature curable second resin component which is non-curable under actinic radiation conditions effective for curing the first resin component, wherein a first portion of the self-leveling liquid composition comprising the second resin component but not the first resin component is provided in the housing to form a first self-leveling liquid layer therein, and a second portion of the self-leveling liquid composition comprising the first resin component is provided in the housing to form a separate and discrete second self-leveling liquid layer overlying the first liquid layer, wherein the first and second resin components are provided in sufficient proportions relative to one another so that actinic radiation curing of the first resin component immobilizes the resulting partially cured mass of the composition;

(ii) prior to curing of the second resin component, exposing the self-leveling liquid composition to actinic radiation which is curingly effective for the first resin component; and

(iii) thereafter exposing the composition to ambient temperature conditions which are curingly effective for the second resin component.

The absence of migrative movement of the potting mass and gas channelling through the mass during its cure is achieved by the proportions and cures of the first and second resin components being such that the actinic radiation curing of the first resin component:

(i) immobilizes the resulting partially cured mass of the composition throughout the subsequent curing of the second resin component, and

(ii) renders the resulting partially cured mass of the composition impermeable to gas channelling void formation throughout the subsequent curing of the second resin component.

In another aspect, the invention relates to a method as described above, in which the actinic radiation curable first resin component is a: (a) (meth)acrylic resin, (b) vinyl monomer, (c) unsaturated polyester solubilized in vinyl monomers, or (d) an epoxy resin.

A further aspect of the invention relates to a method as described above, in which the second resin component is cured under ambient temperature one or more of the following curing conditions selected from conditions: (a) moisture exposure; (b) reaction with curative species; (c) in situ formation of curative species; or (d) actinic radiation exposure differing from the actinic radiation exposure which is curingly effective for the first resin component.

In the aspect of the invention relating to a method as broadly described above, the cured mass comprises the first resin component in a separate and discrete layer in the mass, with such first resin component-containing layer overlying a layer comprising the second resin component but not the first resin component. This aspect of the invention is particularly advantageous when the depth of the housing to be filled with the potting resin mass is deeper than 3.05 mm (120 mils), since it is generally difficult for actinic radiation to penetrate to a depth significantly beyond this level in resinous media. In this instance, the provision of the actinic radiation curable resin in an overlayer which is of a thickness not exceeding 3.05 mm (120 mils) permits ready actinic radiation cure resulting in immobilization (containment) of the underlying second resin component-containing layer prior to its curing.

Other aspects of the invention relating to a method as described above include:

the second resin component is an epoxy resin, silicone, or urethane;

the thickness of the cured composition mass being greater than 1.06 mm (40 mils) and preferably greater than 1.524 mm (60 mils);

the second resin component being an epoxy resin and the housing being formed of a material selected from the group consisting of polybutylene terephthalate and polyphenylene sulfone;

the second resin component being a cycloaliphatic epoxy resin which is cured with an acid anhydride

3

curative; and

the housing having an opening therein through which a structural element is extended and joined to the potted mechanism in the housing.

Another aspect of the invention relates to a device comprising a housing containing a mechanism and a self-leveling liquid composition characterized in that the liquid composition comprises an actinic radiation curable first resin component and an ambient temperature curable second resin component which is non-curable under actinic radiation conditions effective for curing the first resin component, wherein a first portion of the self-leveling liquid composition comprising the second resin component but not the first resin component is provided in the housing to form a first self-leveling liquid layer therein, and a second portion of the self-leveling liquid composition comprising the first resin component is provided in the housing to form a separate and discrete second self-leveling liquid layer overlying the first liquid layer, wherein the first and second resin components are provided in sufficient proportions relative to one another so that actinic radiation curing of the first resin component immobilizes the resulting partially cured mass of the composition, and wherein the first resin component is cured and the second resin component is non-cured.

A further aspect of the invention relates to a method as described above in which the housing has an opening wherein through which a structural element is extended and joined to the potted mechanism after curing of the composition, and the viscosity and wetting properties of the self-leveling liquid composition dispensed into the housing prevent occlusion of the opening by the dispensed liquid composition until it is immobilized by actinic radiation curing of the first resin component.

In the present invention a first portion of the self-leveling liquid composition comprising the second resin component but not the first resin component is dispensed into the housing, followed by dispensing of a second portion of the self-leveling liquid composition comprising the first resin component, so that the respective dispensed first and second portions form separate and discrete layers in the housing.

As used herein, the term "potting" in reference to an electrical/mechanical component refers to sealing of the component with a bulk mass, having a thickness of at least 0.13 mm (5 mils), of a curable composition which has been appropriately cured.

The term "self-leveling liquid" used in reference to the potting composition employed in the invention means that the composition as initially dispensed into the housing of the device has viscosity and wetting characteristics which cause the composition mass to establish a substantially level free surface in the housing without the imposition of external force or work thereon.

The electrical/mechanical device potted by the method of the invention may be any suitable device which is electrical/mechanical in character comprising a housing containing a mechanism which may usefully be potted by a resinous composition.

As used herein, the term "electrical/mechanical" is intended to be broadly construed to include electrical and/or mechanical devices, and in such context, "electrical" will be understood to refer to conventional electrical devices as well as to electronic devices.

Illustrative of the electrical/mechanical devices usefully employed in the broad practice of the invention are variable resistance-type potentiometers, capacitors, printed circuit board switches, solenoids and resistors.

The potting composition utilized in the invention comprises an actinic radiation curable first resin component and a second resin component which is subsequently cured after actinic radiation exposure curing of the first resin component and thus is non-cured under actinic radiation conditions effective for curing the first resin component.

The first resin component may comprise any suitable resin which under actinic radiation conditions may be cured to such extent as to immobilize the resulting partially cured mass of the composition comprising the first and second resin components, i.e., spatially fix the location of the partially cured compositon mass so that it does not migrate during the subsequent cure of the second resin component, while simultaneously rendering the partially cured mass of the composition impermeable to gas channeling void formation during the subsequent cure of the second resin component.

Suitable first resin components of the composition may include (meth)acrylic resins, vinyl monomers, unsaturated polyesters solubilized in vinyl monomers, and epoxy resins.

As used herein, the term "(meth)acrylic" is intended to be broadly construed to include acrylic as well as methacrylic compounds, e.g., acrylic esters and methacrylic esters.

Useful acrylic resins include esters and amides of (meth)acrylic acid as well as comonomers thereof with other copolymerizable monomers. Illustrative esters include methyl acrylate, methyl methacrylate, hydroxy ethyl acrylate, butyl methacrylate, octyl acrylate, and 2-ethoxy ethyl acrylate. Illustrative amides include butoxymethyl acrylamide, methacrylamide, and tert-butyl acrylamide. Also suitable are copolymers of such compounds, and copolymers with other monomers containing polymerizable vinyl groups.

Polyacrylates are generally useful, including 1,3-butylene glycol diacrylate, diethylene glycol diacrylate, 1,6-hexanediol diacrylate, neopentyl glycol diacrylate, polyethylene glycol diacrylate, tertaethylene glycol diacrylate, triethylene glycol diacrylate, pentaerythritol tetraacrylate, tripropylene glycol diacrylate, ethoxylated bisphenol-A-diacrylate, trimethylolpropane triacrylate, di-trimethylolpropane tetraacrylate, dipentaerythritol pentaacrylate, pentaerythritol triacrylate, and the corresponding methacrylate compounds. Also useful are reaction products of (meth)acrylic acid and epoxide resins, and urethane acrylic resins. Suitable poly(meth)acrylate ester compounds are also described in U.S. Patents 4,051,195; 2,895,950; 3,218,305; and 3,425,988.

It will be understood that the foregoing listing of (meth)acrylic compounds is intended only to be illustrative in character, and that any other resin compounds having (meth)acrylic functionality in their molecules and curable under actinic radiation conditions may be potentially employed.

Among the foregoing compounds, (meth)acrylic acid esters are preferred, with the most preferred compounds being (meth)acrylic acid esters of polyhydric alcohols, such as ethoxylated trimethylolpropane triacrylate and dipentaerythritol monohydroxy pentaacrylate.

Another class of resins which are actinic radiation curable and potentially suitable for use in the compositions in the invention include vinyl monomers such as styrene, vinyl toluene, vinyl pyrrolidone, vinyl acetate, divinyl benzene, and the like.

A further class of actinic radiation curable first resin component materials comprises unsaturated polyesters solubilized in vinyl monomers, as ordinarily prepared from alpha-beta ethylenically unsaturated polycarboxylic acids and polyhydric alcohols, as described for example in U.S. Patent 4,025,407.

Yet another class of actinic radiation curable first resin component materials comprises UV curable epoxy resins, including cycloaliphatic epoxides such as limonene dioxide, limonene oxide, alpha-pinene oxide, aliphatic epoxides such as butyl diglycidyl ether, and neopentyl glycol diglycidyl ether, as illustratively disclosed in U.S. Patent 4,412,048.

As used herein, "actinic radiation" means electromagnetic radiation having a wavelength of about 700 nm or less which is capable, directly or indirectly, of curing the specified resin component of the potting composition. By indirect curing in this context is meant curing under such electromagnetic radiation conditions as initiated, promoted or otherwise mediated by another compound.

Although it is an essential requirement of the invention that the first resin component be actinic radiation curable, the second resin component may or may not be so curable, depending on the cure and resin composition desired; if both first and second resins are actinic radiation curable, however, it is further required that the second resin component be non-cured under actinic radiation conditions which are effective for curing the first resin component.

Accordingly, photoinitiators may be added to the composition in an amount effective to respond to the actinic radiation and to initiate and induce curing of the associated resin, via substantial polymerization thereof.

Suitable photoinitiators useful with ultraviolet (UV) actinic radiation curing of (meth)acrylic and vinyl monomers include free radical generating UV initiators such as benzophenone, diethoxy-acetophenone, benzoin methyl ether, benzoin ethyl ether, benzoin isopropyl ether, diethoxy-xanthone, chloro-thio-xanthone, azo-bis-isobutyronitrile, N-methyl diethanol-amine-benzophenone, and mixtures thereof.

Visible light initiators include camphoroquinone/peroxyester initiators and 9-fluorene carboxylic acid peroxyesters.

Infrared initiators include cumeme hydroperoxide, benzoyl peroxide, asobisisobutyronitrile, and like azo and peroxide compounds.

If the actinic radiation curable first resin component is an epoxy resin, the photoinitiator may be a UV initiator which in the presence of UV light, liberates a Lewis acid and/or Bronsted acid, such as iodonium salts, sulfonium salts, arsonium salts, and diazonium salts.

The amount of the photoinitiator required for a given composition may be readily determined by the expedient of simple experiment, without undue effort. In general, however, in the case of (meth)acrylic and vinyl first resin components, amounts of photoinitiator on the order of 0.1-10 percent by weight, and preferably 0.5-5 percent by weight, based on the weight of the resin component, have been found satisfactory. In the case of UV curable epoxies, the Lewis acid/Bronsted acid-releasing initiator may generally be present in the composition at a concentration of 1-5 percent by weight, based on the weight of the epoxy resin.

The second resin component of the potting composition may be any suitable resin which is compatible with the composition comprising the first resin component and which, as indicated, is ambient temperature curable and non-curable under the actinic radiation conditions which are curingly effective for the first resin component.

EP 0 313 574 B1

The second resin component thus may be curable under ambient temperature curing conditions selected from one or more of the following conditions: (a) moisture exposure, (b) reaction with curative species, (c) in situ formation of curative species, or (d) actinic radiation exposure differing from the actinic radiation exposure which is curingly effective for the first resin component.

Illustrative of second resin component are epoxy resins, silicones, and urethanes.

Epoxy resins potentially suitable for use as the second resin component of the potting composition include those materials having at least one polymerizable epoxy group per molecule, and preferably two or more such groups per molecule. Suitable epoxy resins include those derived from epichlorohydrin and dihydric phenols, e.g., resorcinol, hydroquinone, bisphenol A, p-p'-dihydroxybenzophenone, p-p'-dihydroxydiphenyl, p-p'-dihydroxydiphenyl ethane, bis (2-hydroxynaphthyl) ethane, and 1,5-dihydroxynaphthalene, with bisphenol A being preferred. The epoxy compound may be a cycloaliphatic epoxy, an epoxidized novolak, or a diglycidyl ether of bisphenol A (DGEBA), as described in "Handbook of Epoxy Resins" by Lee and Neville, McGraw-Hill Book Co., New York (1967).

In lieu of the above-described epoxy functional polymerizable monomers, or alternatively in association therewith, various epoxidized rubbers may be utilized in the potting compositions used in the invention as the second resin component, such materials being well known in the art.

A useful class of such epoxidized rubbers are epoxidized carboxy terminated butadiene acrylonitrile copolymers sold under the name of Kelpoxy by Spencer Kellogg (Kelpoxy is a Registered Trade Mark), and epoxidized polybutadiene, for example Oxiron 2001 commercially available from FMC Corporation (Oxyron is a Registered Trade Mark). Still other suitable rubber epoxy additives are the various polymers sold by B.F. Goodrich Company under the name HYCAR (HYCAR is a Registered Trade Mark).

Epoxies are preferred second resin components in the potting compositions employed in the invention, for the reasons discussed herein in the "Background Art" section hereof. As there indicated, a wide variety of curatives and curing conditions may be employed to cure various epoxy resins.

Another class of potential second resin component materials includes silicones such as RTV silicones, e.g., oxime polysiloxane materials. Such silicones may suitably be moisture cured in a conventional known manner.

A further class of potential second resin component materials includes polyurethane resins, including moisture curable polyurethane resins formed as condensation products of polyisocyanates and active hydrogen-containing compounds. The active hydrogen compounds may for example be polyesters prepared from polycarboxylic acids and polyhydric alcohols, polyhydric polyalkylene ethers having at least two hydroxy groups, polythioether glycols or polyester amides.

The foregoing classes of potential second resin component materials are illustrative of character, it being understood that any other resin materials which are compatible with the potting composition comprising the first resin component and efficacious for the potting usage of the composition may advantageously be employed.

Other resins which may be usefully employed as second resin components, depending on the identity of the first resin component and the desired characteristics of the potting composition, include alkyd resins, acrylic resins, and aminoplast resins.

The specific relative proportions of the respective first and second resin components in the potting composition as necessary or appropriate for a given application may be readily determined by simple experiment to determine if the particular ratio chosen meets the potting compositon criteria of the invention, viz., the proportions and cures of the first and second resin components must be such that the actinic radiation curing of the first resin component:

(i) immobilizes the resulting partially cured mass of the composition throughout the subsequent curing of the second resin, and

(ii) renders the resulting partially cured mass of the composition impermeable to gas channeling void formation throughout the subsequent curing of the second resin component.

These criteria may readily be assessed empirically by sample measurement, porosimetry tests or visual inspection, without undue experimentation by one of ordinary skill in the art.

In the broad practice of the invention, the concentration of the first resin component may suitably be on the order of from 1 to 50 percent by weight, based on the total weight of the first and second resin components in the potting composition. If the first resin component is present at concentrations below about 1 percent, there is generally insufficient immobilization of the potting composition, so that it is susceptible to migration and permeable to void formation due to gas channeling, until the second resin component is cured. If, on the other hand, the concentration of the first resin component is above about 50 percent, there tends to be insufficient second resin component present to provide the desired ultimate physical and performance properties in the finally cured potting composition.

6

Based on the foregoing considerations, highly desirable potting compositions used according to the invention may employ the first resin component at a concentration of from 1 to 30 percent by weight, based on the total weight of the first and second resin components in the composition.

Preferred concentrations of the first resin component in the potting composition, particularly when the first resin component is a (meth)acrylic resin and the second resin component is an epoxy resin, are from 5 to 20 percent by weight, most preferably from 5 to 10 percent by weight, based on the total weight of the first and second resin components.

The potting compositions of the invention may suitably contain any further components necessary or desirable for the specific intended end use and curing schedule. Examples include stabilizers, antioxidants, pigments, fillers, surfactants, tackifiers and adhesion promotors.

In accordance with the invention, the device to be potted, comprising a mechanism in a housing, is appropriately positioned and the potting compositon is dispensed into the housing as a self-leveling liquid. Such self-leveling characteristic is provided by proper formulation of the composition to yield the necessary viscosity and wetting behavior therefor.

The dispensed potting composition then is sequentially subjected to the respective curing conditions of the first and second resin components, i.e., a first actinic radiation exposure which is curingly effective for the first resin component and a second cure exposure effective to cure the second resin component.

It will be appreciated that it may be desirable in some instances to deploy more than two resin components in the potting composition, each of which is in turn cured, and that such polymodal cure compositions are within the purview of the invention.

The thickness of the fully cured composition which is provided in the housing of the electrical/mechanical device after the cure of the respective resin components will depend on a number of variables, including the character of the composition, the nature of the mechanism to be protected and the intended end use environment. In general, however, the thickness of the cured potting composition will preferably be greater than about 1.02 mm (40 mils) and most preferably greater than about 1.52 mm (60 mils).

Potting compositions used according to the invention may be formulated for effective performance for various housing materials (materials of construction for the device housing). In case of electrical and electromechanical devices, high strength, temperature resistant materials such as polybutylene terephthalate, commercially available under the trademark Valox, and polyphenylene sulfide, commercially available under the trademark Ryton, have come into wide usage. For these materials, potting compositions containing epoxy resins as the second resin components are preferred, due to the fact that suitable second resin epoxies will generally have a coefficient of thermal expansion which is close to the thermal expansion coefficients of these materials of construction.

The invention is practiced in that the self-leveling liquid composition of the invention is formed by separate and discrete potting layers, comprising a lower resin layer comprising the second resin component but not the first resin component, and an overlying resin layer comprising the first resin component.

Thus, a first portion of the self-leveling liquid potting composition, comprising the second resin component but not the first resin component, is initially dispensed to form the lower portion of the final potting mass, and is filled into the housing up to about 3.05 mm (120 mils) or less from the desired top surface of the final potting mass. The second portion of the self-leveling liquid potting composition, comprising the first resin component, then is dispensed to form a separate and discrete layer on top of the previously dispensed resin layer, to complete the potting mass to the required overall depth of the potting composition. The latter layer has a depth not greater than about 3.05 mm (120 mils), since actinic radiations of a wavelength and intensity which is effective for curing the first resin component typically do not penetrate into the resin mass beyond about 3.05 mm (120 mils).

Subsequent to the dispensing of the respective resin layers, the top layer comprising the first resin component is subjected to actinic radiation curing effective therefor. The result is a top resin layer comprising the fully cured first resin component, overlying an uncured lower layer comprising the second resin component. The second resin component then is suitably cured by the provision of curing conditions effective therefor.

In a particularly preferred embodiment, the first resin component in the dual-layer system is a (meth)-acrylic resin curable by UV radiation, and the second resin component is a room temperature curing epoxy, e.g., an epoxy resin having a cure time at ambient (room temperature) conditions of 2 to 24 hours.

The practice of the invention with the formation and curing of separate and discrete contiguous resin layers is, as indicated, useful where the depth of the potting mass is greater than about 3.05 mm (120 mils) in the housing.

7

Such dual-layer formation of the potting mass in the housing has a further advantage associated with the fact that many actinic radiation curable resin components have a significantly greater cost than resins curable by other methods. As an example, in the case of UV-curable acrylic resins and room temperature curing epoxy resins, the cost ratio may be on the order of about 10, i.e., the cost on a unit volume basis of the acrylic resin is about 10 times that of the room temperature curing epoxy material. Accordingly, the dual-layer potting mass, in which the upper layer comprising the first resin component layer is generally less than 3.05 mm (120 mils) in thickness, provides a significant cost savings relative to homogeneous mixtures of the respective first and second resin components, in addition to overcoming the actinic radiation cure problems incident to increased depths of resin, above about 3.05 mm (120 mils), as previously described.

Further, it has been surprisingly and unexpectedly discovered that the bonding between the respective resin layers in the dual-layer mode of practicing the invention is excellent, and does not result in delamination or separation of the respective layers after curing, even under intensive thermal cycling conditions, when the upper layer comprises both the first and second resin components, and the lower layer comprises the second resin component but does not contain any first resin component.

It will be apparent from the foregoing discussion of the dual-layer mode of practicing the invention that the separate and discrete character of the respective resin layers must be continually maintained from the initial dispensing of these layers through their respective final cures. Accordingly, it is generally desirable to utilize a layer comprising the first resin component in such systems having a significantly lower specific gravity than the underlying resin layer comprising the second resin component but not the first resin component, so that the first resin component-containing layer "floats" on the underlying layer, and/or to provide the underlying resin layer of a formulation having sufficient viscosity so that the separate and discrete characters of the respective layers is maintained.

The invention may for example be advantageously practiced with a room temperature curing epoxy resin and a UV-curable acrylic resin in an upper layer having a specific gravity in the range of from 1.0-1.2, in combination with a separate and discrete lower layer containing a room temperature curing epoxy and having a specific gravity in the range of from 1.4-1.7.

In general, in the formation of separate and discrete layers containing the respective first and second resin components, it is desirable that the upper layer comprising the actinic radiation curable first resin component have a specific gravity which is from 5 to 95 percent of the specific gravity of the underlying layer comprising the second resin component but not the first resin component, more preferably from 15 to 90 percent, and most preferably from 20 to 85 percent.

If the respective upper and lower resin layers are closely similar in specific gravity characteristics, e.g., within 5 to 10 percent of one another, it may be desirable to provide the lower layer in the form of a flowable gel or other high viscosity liquid formulation, so that the upper resin layer, of a suitably lower viscosity, is maintained on the surface of the previously dispensed lower layer. For example, it may be useful to employ as the first resin component in the upper layer a UV-curable acrylic resin, in combination with a room temperature curing epoxy second resin component, with the upper layer having a viscosity on the order of about 4 Pa•s (4000 centipoise), and with a separate and discrete underlying layer containing the room temperature curing epoxy second resin component, wherein the lower layer has a viscosity on the order of about 80 Pa•s (80,000 centipoise).

It will be recognized that in instances of the dual-layer practice of the invention, it may be desirable or necessary to utilize various additives with the respective resin components, to adjust relative specific gravity and viscosity values to facilitate the maintenance of separate and discrete layers comprising the respective resin components. For example, it may be desirable in a given instance to increase the specific gravity and/or viscosity of the lower layer comprising the second resin component but not the first resin component, by addition to the lower resin layer formulation of filler materials, such as for example calcium carbonate, calcium sulfate, clay, talc, or any other suitable materials providing the desired characteristics.

The dual-layer practice of the invention, in which the first and second resin components are utilized to form contiguous separate and discrete resin layers, provides the advantage of quickly immobilizing the potting mass and overcomes the prior art problems of void formation and migration of the potting mass, in a highly efficient and effective manner.

It will be appreciated that in lieu of the formation of two contiguous separate and discrete resip layers as previously described, it may in some instances be desirable to form the potting mass with more than two separate and discrete resin layers, and that all such multilayer potting masses and associated compositions are fully within the purview of the present invention.

EP 0 313 574 B1

Brief Description of Drawings

Figure 1 is a perspective view, shown in cut-away section, of a variable-resistance type potentiometer featuring a multiturn adjustment shaft, which may be usefully potted in accordance with the invention.

Figure 2 is a perspective view of another variable-resistance type potentiometer with a single turn adjustment element, suitable for the practice of the invention, partially cut away to show the details of its construction.

Figure 3a is a partially sectioned elevational view of a solenoidal electronic fuel sensor, in which the solenoidal element may be potted in accordance with the invention; Figure 3b is the corresponding unsectioned end view of the same device.

Figures 4a and b are views of an electrical switch suitable for use as a printed circuit board component, Figure 4a showing a top plan view of the device, and Figure 4b showing a corresponding side view.

Figure 5 is a partially sectioned elevation view of a solenoidal electronic fuel sensor of a type as shown in Figure 3a, featuring a two-layer potting mass according to one embodiment of the invention.

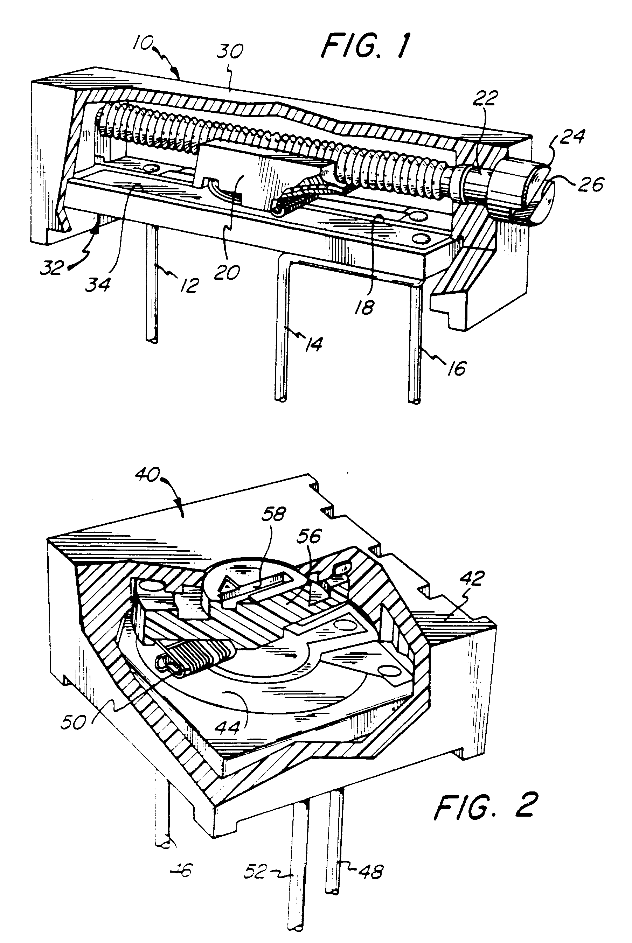

Referring now to the drawings, as showing various illustrative types of devices with which the invention may advantageously be employed, Figure 1 depicts a variable resistance-type potentiometer with a multi-turn adjustment shaft.

The illustrated device 10 is a trimming potentiometer, an electromechanical device with three terminals, 12, 14, and 16. The two terminals 12 and 16 are connected to the ends of a resistive element 18, and the terminal 14 is connected to the movable conductive contact 20 which slides over the element, thus allowing the input voltage to be divided as a function of the mechanical input. The mechanical input is determined by the position of the adjustment shaft 22, of screw-like configuration, having an enlarged end face 24 with adjustment slot 26 therein for rotation of the shaft to the predetermined desired extent. Such adjustment will vary the electrical resistance characteristic of the device over a wide range, depending on the extent of adjustment, e.g., from 10 to 2,000,000 ohms.

The mechanism of the device, comprising resistive element 18 and movable contact 20, is interiorly disposed in a housing 30, whose bottom face 32 is open as shown and which with the associated resistive element 18 defines a recess 34 in the device, into which the potting composition used according to the invention is dispensed. It will be appreciated that for such dispensing operation, the device will be appropriately positioned in an inverted fashion relative to the position shown in Figure 1.

Figure 2 shows a variable resistance-type potentiometer device 40 comprising a housing 42 in which the resistance mechanism is disposed. The mechanism includes a resistive element, to which the terminals 46 and 48 are joined. The movable conductive contact 50 is joined to the third terminal 52, and positioned as desired by the slotted cylindrical head 56 having adjustment slot 58 therein.

As in the case of the Figure 1 device, the device shown in Figure 2 has at its bottom face a recess defined by the housing and the bottom surface of the movable contact into which the potting composition used according to the invention may be dispensed and sequentially cured to provide a cured composition mass as a sealing barrier for the mechanism.

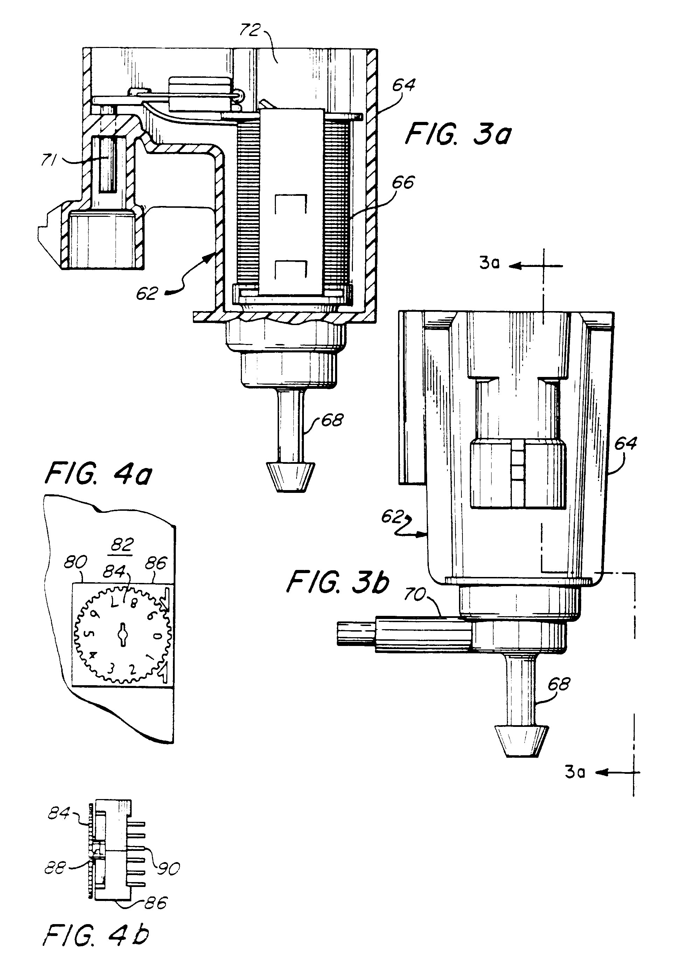

Figures 3a and 3b show, respectively, a partially sectioned side view and a corresponding unsectioned end view of an electronic fuel flow sensor assembly 62 comprising a housing 64 in which is disposed a solenoidal element 66. The view of Figure 3a is along line 3a-3a of Figure 3b.

The solenoidal element 66 is joined by suitable electronic coupling means to female connector elements 71 which permit the sensor assembly to be installed in an automotive electronic system for monitoring fuel flow. The sensor assembly comprises intake port 68 and outlet port 70 providing for fuel flow through the device.

In the housing of the sensor assembly there is an interior space 72 surrounding the solenoidal element 66 and its associated electronic coupling means, to which the potting composition of the invention may be introduced and sequentially cured as previously described.

Figure 4a shows a printed circuit board switch 80 associated with a printed circuit board 82. The switch assembly features a manually actuatable switching member 84 mounted on housing 86 which by manual rotation is set to a predetermined position for operation of the printed circuit board.

As best shown in Figure 4b, a corresponding side view of the switch (with the printed circuit board omitted for clarity), the switching member 84 is joined via shaft 88 to the interiorly disposed mechanism in the housing 86 (not shown). The internal mechanism in turn is joined to the terminals 90, which are soldered or otherwise connected to the circuitry of the printed circuit board.

The interiorly disposed mechanism of the device shown in Figure 4b defines with the housing thereof a recess in which a cured composition mass is potted in accordance with the invention. The thickness t of the potting mass may suitably be on the order of 0.56 mm (22 mils).

9

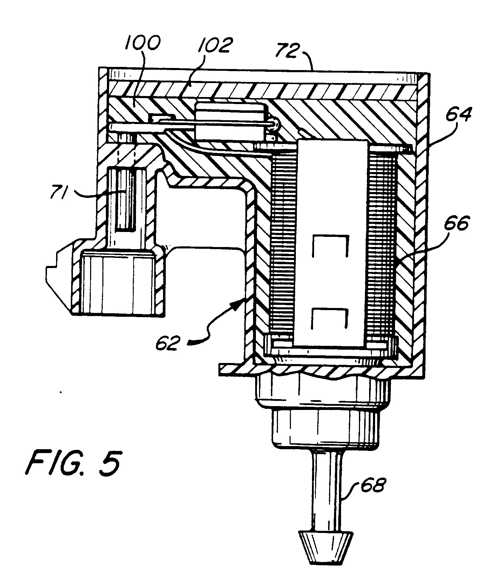

Figure 5 is a partially sectioned side view of an electronic fuel flow sensor assembly of the type previously described with reference to Figure 3a (the same reference numbers as utilized in Figure 3a being employed in Figure 5), with a potting mass in the interior space 72 comprising a lower resin layer 100 and an upper resin layer 102.

The lower resin layer 100 may suitably be formed from a composition comprising a room temperature curing epoxy resin, as initially dispensed into the housing 64 to fill the housing to a depth to within 2.54 mm (100 mils) of the desired final top surface of the potting mass. The lower layer material may for example have a viscosity of 80 Pa•s (80,000 centipoise) and a specific gravity of 1.4, as initially dispensed, with a curing time at room temperature conditions on the order of 2 hours. Subsequent to dispensing of the epoxy resin-containing composition to form the lower layer 100, the upper layer 102 is formed by dispensing into the housing onto the previously dispensed lower resin layer a composition comprising an acrylic resin which is UV curable, in combination with the same type room temperature curing epoxy resin used in the lower layer. Such upper layer may have a viscosity of about 4 Pa•s (4,000 centipoise) and a specific gravity of about 1.0. The depth of the upper resin layer 102 is 2.54 mm (100 mils).

Subsequent to the dispensing of the acrylic/epoxy resin formulation to form the upper layer 102, the potting mass is subjected to suitable UV radiation which is curingly effective for the acrylic resin. There is formed, as a result of such curing radiation exposure, an upper cured layer overlying the uncured lower resin layer comprising the room temperature curing epoxy resin. At this point, the flow sensor assembly is fully handleable, and may be packaged, transported, installed, etc., without adverse effect, as the epoxy layer progressively cures under ambient conditions.

The features and advantages of the invention are further illustrated with respect to the following non-limiting examples, wherein all parts and percentages are by weight unless otherwise expressly stated.

EXAMPLE

The present example is directed to an illustrative embodiment of the invention wherein the potting mass is formed as comprising two separate and discrete resin layers contiguous to one another.

A lower layer resin formulation was made up having the composition shown in Table I below.

## TABLE I

| Component | Concentration, % |
|---|---|
| Part A | |
| diglycidyl ether bisphenol A | 39.75 |
| fumed silica | 1.15 |
| iron oxide | 15 |
| barium sulfate | 20 |
| calcium carbonate | 21.92 |
| Epi-Rez SU3 polyfunctional epoxy resin (Interez Corp, Louisville, Kentucky) | 2.13 |
| Part B | |
| barium sulfate | 17.39 |
| aluminum silicate | 7.25 |
| calcium carbonate | 43.48 |
| Dow epoxy hardener DEH20 (Dow Chemical Company, Midland, Michigan) | 3.62 |
| Emerez 1612 polyamide epoxy (Emery Corporation, Cincinnati, Ohio) | 25.63 |
| titanium dioxide | 2.9 |

Parts A and B of the Table I formulation were thoroughly mixed with one another to form a liquid resin composition having a specific gravity of 1.7. This resin had a pot life of two hours and a cure time to achieve full properties of 24 hours at 23°C.

This epoxy resin formulation was dispensed into the housing of a fuel flow sensor assembly of the type shown in Figure 5, constructed of nylon and having an interior volume of 18 cubic centimeters. 18 grams of the formulation were dispensed to provide a first layer of the potted mass in the interior volume of the housing, whose upper surface was approximately 3.05 mm (120 mils) from the final desired top surface of the potting mass.

A resin composition comprising a UV-curable resin and a (non-UV curable) room temperature curbable epoxy resin was prepared, mixing through static mixing elements equal weights of Parts A and B of the formulation set forth in Table II below.

## TABLE II

| Component | Concentration, % |
|---|---|
| **Part A** | |
| diglycidyl ether bisphenol A | 75.3 |
| (Dow Quatrex 1010) | |
| dipentaerythritol monohydroxy pentaacrylate | 21.0 |
| 1-benzoyl cyclohexanol | 3.0 |
| organic air release agent (BYKA501) | 0.5 |
| Pennco Blue Pigment (Penn Color) | 0.2 |
| **Part B** | |
| polyoxypropyleneamine | 22.73 |
| (Texaco Jeffamine D230) | |
| aluminum oxide | 68.18 |
| C17 aliphatic acrylate (Kayard R644) | 9.09 |

This composition, having a specific gravity of 1.2, was dispensed into the housing on top of the previously dispensed first resin layer to provide an additional depth of 2.54 mm (100 mils) to the overall potting mass.

The resulting two-layer potting mass was then exposed to UV radiation having a wavelength of 360 nanometers at an intensity of 100,000 microwatts per square centimeter for 5 seconds. The composition following such radiation exposure was sufficiently immobilized for the device to be packaged and shipped to an end user.

Following room temperature curing of the two-layer potting mass for 24 hours at ambient conditions, the flow sensor device was evaluated by thermal shock testing.

In this test, the flow sensor device underwent ten thermal shock cycles between -50°C and 120°C, being held at each of the temperature extremes for one hour prior to sudden exposure to the other temperature extreme for a like period.

Following thermal shock cycling, the sensor article was sectioned to evaluate the character of the interface between the respective resin layers, and the adhesion of the potted mass to the walls of the sensor device. It was suprisingly and unexpectedly discovered that there was no interlayer delamination between the respective layers, and no delamination of the potting mass at its juncture with the walls of the device to which the potting mass had adhered. In addition, no evidence of migration or gas channeling void formation was observed in the cured potting mass.

It is to be noted that the device in this example employed an upper layer in the potting mass comprising both UV curable and non-UV curable resin components. In some instances, it may be desirable to utilize only UV curable resin component(s) in the upper resin layer, and it is thus within the broad purview of the present invention to utilize both UV and non-UV curable resin components, or alternatively to use only one or more UV curable resins, in such upper layer.

### Best Mode For Carrying Out The Invention

The best mode of practicing the present invention involves the use of a (meth)acrylic acid ester which is curable by actinic radiation as a first resin component, in combination with an epoxy resin as the second resin component, and involves forming the cured mass of the potting composition with contiguous discrete and separate resin layers, with the upper layer containing the first resin component (the actinic radiation-curable component) and a second resin component which is non-cured under the actinic radiation conditions curingly effective for the first resin component, overlying a lower layer containing the second resin component but not the first resin component. The Example illustrates this mode of carrying out the invention for a UV curable acrylic resin as the preferred first resin component and an ambient temperature cured epoxy resin as the second resin component.

In the two-layer mode of practicing the invention, the upper layer desirably contains the same second resin component as utilized in the lower resin layer of the potting mass, so that there is co-curing of the second resin components across the interface between the respective upper and lower layers, to provide good cohesion and continuity characteristics at such interface, so that delamination and morphological defects due to differential thermal expansion and contraction between the respective layers is minimized. In this respect, the coefficients of thermal expansion and contraction for the respective upper and lower layers are advantageously closely matched to provide optimal structural integrity and performance characteristics.

The best mode of practicing the invention involves the use of a (meth)acrylic acid ester as the first resin component, and an epoxy resin, preferably a room temperature curing epoxy resin, as the second resin component.

Industrial Applicability

The present invention has broad applicability to the production of electrical/mechanical devices such as variable resistance-type potentiometers, capacitors, printed circuit board switches, solenoids, resistors, fluid flow sensors, and the like, which are reliably and efficiently sealed against environmental contact with the internal elements thereof. Such devices potted in accordance with the present invention are free of the curingly caused migrative movement of the potting mass in the housing and fouling incident to the use of prior art single resin component potting compositions.

**Claims**

1. A method of potting a device including a mechanism in a housing, characterized in that it comprises:
   (i) providing in the housing a self-leveling liquid composition comprising an actinic radiation curable first resin component and an ambient temperature curable second resin component which is non-curable under actinic radiation conditions effective for curing the first resin component, wherein a first portion of the self-leveling liquid composition comprising the second resin component but not the first resin component is provided in the housing to form a first self-leveling liquid layer therein, and a second portion of the self-leveling liquid composition comprising the first resin component is provided in the housing to form a separate and discrete second self-leveling liquid layer overlying the first liquid layer, wherein the first and second resin components are provided in sufficient proportions relative to one another so that actinic radiation curing of the first resin component immobilizes the resulting partially cured mass of the composition;
   (ii) prior to curing of the second resin component, exposing the self-leveling liquid composition to actinic radiation which is curingly effective for the first resin component; and
   (iii) thereafter exposing the composition to ambient temperature conditions which are curingly effective for the second resin component.

2. A method as claimed in Claim 1, characterized in that the actinic radiation curable first resin component is a (meth)acrylic resin, a vinyl monomer, an unsaturated polyester solubilized in a vinyl monomer or an epoxy resin.

3. A method as claimed in Claims 1 or 2, characterized in that the actinic radiation curable first resin component is a (meth)acrylic acid ester.

4. A method as claimed in Claim 1, characterized in that the second resin component is an epoxy resin, a silicone or a urethane.

5. A method as claimed in Claim 4, characterized in that the curable second resin component is cured under ambient temperature curing conditions selected from one or more of the following conditions: (a) moisture exposure; (b) reaction with curative species; (c) in situ formation of curative species; or (d) actinic radiation exposure differing from the actinic radiation exposure which is curingly effective for the first resin component.

6. A method as claimed in Claims 4 or 5, characterized in that the second resin component comprises an epoxy resin and a curative therefor, wherein the curative is an amine, a latent amine, an acid anhydride, a dissociable amine salt, a cationic catalyst, a dicyandiamide, or a compatible mixture thereof.

7. A method as claimed in Claim 6, characterized in that the overlying layer comprises a UV-curable acrylic resin as the first resin component, and the underlying layer comprises a room temperature curable epoxy as the second resin component, with the specific gravity of the overlying layer being in the range of from 1.0 to 1.2, and the specific gravity of the underlying layer being in the range of from 1.4 to 1.7.

8. A method as claimed in any of Claims 1 to 7, characterized in that the thickness of the cured composition mass is greater than 1.02 mm (40 mils).

9. A method as claimed in any of Claims 1 to 8, characterized in that the thickness of the layer comprising the first resin component does not exceed 3.05 mm (120 mils).

10. A method as claimed in any of Claims 1 to 9, characterized in that the concentration of the first resin component in the composition is from 1 to 50 percent by weight, based on the total weight of the first and second resin components in the composition.

11. A method as claimed in Claim 10, characterized in that the concentration of the first resin component in the composition is from 5 to 20 percent by weight, based on the total weight of the first and second resin components in the composition.

12. A method as claimed in any of Claims 1 to 11, characterized in that the specific gravity of the layer comprising the first resin component prior to its curing is from 5 to 95 percent of the specific gravity of the underlying layer comprising the second resin component.

13. A method as claimed in Claim 12, characterized in that the underlying layer additionally comprises an inert filler.

14. A method as claimed in Claim 4, characterized in that the second resin component is an epoxy resin, and the housing is formed from polybutylene terephthalate or polyphenylene sulfide.

15. A method as claimed in Claim 14, characterized in that the housing has an opening therein through which a structural element is extended and joined to the potted mechanism in the housing.

16. A method as claimed in any of Claims 1 to 15, characterized in that the potted device is an electronic liquid flow sensor, a printed circuit board element or a potentiometer.

17. A device comprising a housing containing a mechanism and a self-leveling liquid composition characterized in that the liquid composition comprises an actinic radiation curable first resin component and an ambient temperature curable second resin component which is non-curable under actinic radiation conditions effective for curing the first resin component, wherein a first portion of the self-leveling liquid composition comprising the second resin component but not the first resin component is provided in the housing to form a first self-leveling liquid layer therein, and a second portion of the self-leveling liquid composition comprising the first resin component is provided in the housing to form a separate and discrete second self-leveling liquid layer overlying the first liquid layer, wherein the first and second resin components are provided in sufficient proportions relative to one another so that actinic radiation curing of the first resin component immobilizes the resulting partially cured mass of the composition, and wherein the first resin component is cured and the second resin component is non-cured.

**Patentansprüche**

1. Verfahren zur Einkapseln einer Vorrichtung, die ein Laufwerk einschließt, in ein Gehäuse, dadurch gekennzeichnet, daß es umfaßt:
   (i) die Bereitstellung einer selbstnivellierenden flüssigen Zusammensetzung umfassend eine durch actinische Strahlung härtbare erste Harzkomponente und eine bei Umgebungstemperatur härtbare, unter actinischen Strahlungsbedingungen nicht härtbare, zweite Harzkomponente, die zur Härtung der ersten Harzkomponente wirksam ist, wodurch ein erster Teil der selbstnivellierenden flüssigen Zusammnensetzung, der die zweite Harzkomponenten, jedoch nicht die erste Harzkomponente umfaßt, in dem Gehäuse bereitgestellt wird, um darin eine erste, selbstnivellierende flüssige Schicht zu bilden, und ein zweiter Teil der selbstnivellierenden flüssigen Zusammnensetzung, die die erste Harzkomponente umfaßt, in dem Gehäuse bereitgestellt wird, um eine getrennte und diskrete zweite selbstnivellierende flüssige Schicht zu bilden, die über der ersten flüssigen Schicht liegt, wodurch die erste und die zweite Harzkomponente in ausreichenden Anteilen relativ zueinander bereitgestellt werden, so daß das Härten durch die actinische Strahlung der ersten Harzkomponente die resultierende teilweise gehärtete Masse der Zusammensetzung immobilisiert;
(ii) vor dem Härten der zweiten Harzkomponente die Exposition der selbstnivellierende flüssigen Zusammensetzung durch eine actinische Strahlung, die für die erste Harzkomponente härtend wirksam ist; und
(iii) danach die Exposition der Zusammensetzung durch Umgebungstemperatur-Bedingungen, die für die zweite Harzkomponente härtend wirksam sind.

2. Verfahren nach Anspruch 1, dadurch gekennzeichnet, daß die durch actinische Strahlung härtbare erste Harzzusammensetzung ein (Meth)acrylharz, ein Vinylmonomeres, ein ungesättigter Polyester, solubilisiert in einem Vinylmonomeren oder einem Epoxyharz, ist.

3. Verfahren nach den Ansprüchen 1 oder 2, dadurch gekennzeichnet, daß die durch actinische Strahlung härtbare erste Harzkomponente ein (Meth)acrylsäureester ist.

4. Verfahren nach Anspruch 1, dadurch gekennzeichnet, daß die zweite Harzkomponente ein Epoxyharz, ein Silicon oder ein Urethan ist.

5. Verfahren nach Anspruch 4, dadurch gekennzeichnet, daß die härtbare zweite Harzkomponente bei Umgebungstemperatur-Härtungsbedingungen, ausgewählt aus einer oder mehreren der folgenden Bedingungen: (a) Feuchtigkeitsexposition; (b) Reaktion mit einem Härtungsstoff; (c) in situ-Bildung des Härtungsstoffes oder (d) actinische Strahlungsexposition, die sich von der actinischen Strahlungsexposition unterscheidet, die für die erste Harzkomponente härtend wirksam ist, gehärtet wird.

6. Verfahren nach den Ansprüchen 4 oder 5, dadurch gekennzeichnet, daß die zweite Harzkomponente ein Epoxyharz und ein Härtungsmittel dafür umfaßt, worin das Härtungsmittel ein Amin, ein latentes Amin, ein Säureanhydrid, ein dissoziierbares Aminsalz, ein kationischer Katalysator, ein Dicyandiamid oder ein kompatibles Gemisch davon ist.

7. Verfahren nach Anspruch 6, dadurch gekennzeichnet, daß die darüberliegende Schicht ein UV-härtbares Acrylharz als erste Harzkomponente umfaßt und die darunterliegende Schicht ein bei Raumtemperatur härtbares Epoxyharz als zweite Harzkomponente umfaßt, wobei sich das spezifische Gewicht der darüberliegenden Schicht im Bereich von 1,0 bis 1,2 und das spezifische Gewicht der darunterliegenden Schicht im Bereich von 1,4 bis 1,7 bewegen.

8. Verfahren nach einem der Ansprüche 1 bis 7, dadurch gekennzeichnet, daß die gehärtete zusammengesetzte Masse größer als 1,02 mm (40 mils) ist.

9. Verfahren nach einem der Ansprüche 1 bis 8, dadurch gekennzeichnet, daß die Dicke der Schicht, die die erste Harzkomponente umfaßt, 3,05 mm (120 mils) nicht übersteigt.

10. Verfahren nach einem der Ansprüche 1 bis 9, dadurch gekennzeichnet, daß die Konzentration der ersten Harzkomponente in der Zusammensetzung von 1 bis 50 Gew.-% beträgt, bezogen auf das Gesamtgewicht der ersten und zweiten Harzkomponente in der Zusammensetzung.

11. Verfahren nach Anspruch 10, dadurch gekennzeichnet, daß die Konzentration der ersten Harzkomponente in der Zusammensetzung 5 bis 20 Gew.-% beträgt, bezogen auf das Gesamtgewicht der ersten und zweiten Harzkomponente in der Zusammensetzung.

12. Verfahren nach einem der Ansprüche 1 bis 11, dadurch gekennzeichnet, daß das spezifische Gewicht der Schicht, die die erste Harzkomponente umfaßt, vor ihrer Härtung 5 bis 95% des spezifischen Gewichtes der darunterliegenden Schicht, die die zweite Harzkomponente umfaßt, beträgt.

**13.** Verfahren nach Anspruch 12, dadurch gekennzeichnet, daß die darunterliegende Schicht zusätzlich einen inerten Füllstoff umfaßt.

**14.** Verfahren nach Anspruch 4, dadurch gekennzeichnet, daß die zweite Harzkomponente ein Epoxyharz ist und das Gehäuse aus Polybutylenterephthalat oder Polyphenylensulfid gebildet wird.

**15.** Verfahren nach Anspruch 14, dadurch gekennzeichnet, daß das Gehäuse eine Öffnung darin aufweist, durch die ein Bauelement verläuft und mit dem eingekapselten Laufwerk in dem Gehäuse verbunden wird.

**16.** Verfahren nach einem der Ansprüche 1 bis 15, dadurch gekennzeichnet, daß die eingekapselte Vorrichtung einen Durchflußmeßfühler, ein gedrucktes Schaltungstafel-Element oder ein Potentiometer ist.

**17.** Vorrichtung umfassend ein Gehäuse, das ein Laufwerk und eine selbstnivellierende flüssige Zusammensetzung umfaßt, dadurch gekennzeichnet, daß die flüssige Zusammensetzung eine durch actinische Strahlung härtbare erste Harzkomponente und eine bei Umgebungstemperatur härtbare zweite Harzkomponente umfaßt, die unter actinischen Strahlungsbedingungen, die zur Härtung der ersten Harzkomponente wirksam sind, nicht härtbar ist, worin ein erster Teil der selbstnivellierenden flüssigen Zusammensetzung, der die zweite Harzkomponenten, aber nicht die erste Harzkomponente umfaßt, in dem Gehäuse vorgesehen ist, um darin eine erste, selbstnivellierende flüssige Schicht zu bilden, und worin ein zweiter Teil der selbstnivellierenden flüssigen Zusammensetzung, die die erste Harzkomponente umfaßt, in dem Gehäuse vorgesehen ist, um eine getrennte und diskrete zweite selbstnivellierende flüssige Schicht zu bilden, die über der ersten Schicht liegt, worin die erste und die zweite Harzkomponente in ausreichenden Anteilen relativ zueinander vorgesehen sind, so daß die Härtung der ersten Harzkomponente durch die actinische Strahlung die resultierende teilweise gehärtete Masse der Zusammensetzung immobilisiert und worin die erste Harzkomponente gehärtet und die zweite Harzkomponente nicht gehärtet ist.

**Revendications**

**1.** Un procédé d'enrobage d'un dispositif comprenant un mécanisme dans un boîtier, caractérisé en ce qu'il comprend :
(i) l'introduction dans le boîtier d'une composition liquide auto-nivelante comprenant un premier composant résineux durcissable par un rayonnement actinique et un second composant résineux durcissable à la température ambiante qui n'est pas durcissable dans des conditions d'irradiation actinique efficaces pour durcir le premier composant résineux, dans laquelle une première partie de la composition liquide auto-nivelante comprenant le second composant résineux mais non le premier composant résineux est introduite dans le boîtier pour y former une première couche liquide auto-nivelante, et une seconde partie de la composition liquide auto-nivelante comprenant le premier composant résineux est introduite dans le boîtier pour former une seconde couche liquide auto-nivelante séparée et discrète, sur-jacente à la première couche liquide, et dans laquelle les premier et second composants résineux sont introduits en des proportions suffisantes l'un par rapport à l'autre pour que le durcissement par un rayonnement actinique du premier composant résineux immobilise la masse partiellement durcie résultante de la composition ;
(ii) avant le durcissement du second composant résineux, l'exposition de la composition liquide auto-nivelante à un rayonnement actinique qui est efficace pour durcir le premier composant résineux ; puis
(iii) l'exposition de la composition à des conditions à température ambiante qui sont efficaces pour durcir le second composant résineux.

**2.** Un procédé tel que revendiqué dans la revendication 1, caractérisé en ce que le premier composant résineux durcissable par un rayonnement actinique est une résine (méth)acrylique, un monomère vinylique, un polyester insaturé solubilisé dans un monomère vinylique ou une résine époxy.

**3.** Un procédé tel que revendiqué dans la revendication 1 ou 2, caractérisé en ce que le premier composant résineux durcissable par un rayonnement actinique est un ester d'acide (méth)acrylique.

**4.** Un procédé tel que revendiqué dans la revendication 1, caractérisé en ce que le second composant résineux est une résine époxy, une silicone ou un uréthanne.

**5.** Un procédé tel que revendiqué dans la revendication 4, caractérisé en ce que le second composant résineux durcissable est durci dans des conditions de durcissement à la température ambiante choisies parmi l'une ou plusieurs des conditions suivantes : (a) exposition à l'humidité ; (b) réaction avec une espèce durcisseuse ; (c) formation "in situ" d'une espèce durcisseuse ; ou (d) exposition à un rayonnement actinique, différente de l'exposition à un rayonnement actinique qui est efficace pour durcir le premier composant résineux.

**6.** Un procédé tel que revendiqué dans la revendication 4 ou 5, caractérisé en ce que le second composant résineux comprend une résine époxy et un agent durcisseur pour celle-ci, l'agent durcisseur étant une amine, une amine latente, un anhydride d'acide, un sel d'amine dissociable, un catalyseur cationique, un dicyandiamide ou un mélange compatible d'entre eux.

**7.** Un procédé tel que revendiqué dans la revendication 6, caractérisé en ce que la couche surjacente comprend une résine acrylique durcissable par irradiation UV comme premier composant résineux, et la couche sous-jacente comprend un époxyde durcissable à la température ambiante comme second composant résineux, la densité de la couche sur-jacente se situant dans l'intervalle de 1,0 à 1,2, et la densité de la couche sous-jacente se situant dans l'intervalle de 1,4 à 1,7.

**8.** Un procédé tel que revendiqué dans l'une quelconque des revendications 1 à 7, caractérisé en ce que l'épaisseur de la masse de composition durcie est supérieure à 1,02 mm (40 mils).

**9.** Un procédé tel que revendiqué dans l'une quelconque des revendications 1 à 8, caractérisé en ce que l'épaisseur de la couche comprenant le premier composant résineux ne dépasse pas 3,05 mm (120 mils).

**10.** Un procédé tel que revendiqué dans l'une quelconque des revendications 1 à 9, caractérisé en ce que la concentration du premier composant résineux dans la composition est de 1 à 50 pour cent en poids, par rapport au poids total des premier et second composants résineux dans la composition.

**11.** Un procédé tel que revendiqué dans la revendication 10, caractérisé en ce que la concentration du premier composant résineux dans la composition est de 5 à 20 pour cent en poids, par rapport au poids total des premier et second composants résineux dans la composition.

**12.** Un procédé tel que revendiqué dans l'une quelconque des revendications 1 à 11, caractérisé en ce que la densité de la couche comprenant le premier composant résineux avant son durcissement est de 5 à 95 pour cent de la densité de la couche sous-jacente comprenant le second composant résineux.

**13.** Un procédé tel que revendiqué dans la revendication 12, caractérisé en ce que la couche sous-jacente comprend de plus une charge inerte.

**14.** Un procédé tel que revendiqué dans la revendication 4, caractérisé en ce que le second composant résineux est une résine époxy, et le boîtier est constitué de polytéréphtalate de butylène ou de polysulfure de phénylène.

**15.** Un procédé tel que revendiqué dans la revendication 14, caractérisé en ce que le boîtier comporte une ouverture à travers laquelle un élément structural pénètre et se rattache au mécanisme enrobé présent dans le boîtier.

**16.** Un procédé tel que revendiqué dans l'une quelconque des revendications 1 à 15, caractérisé en ce que le dispositif enrobé est un détecteur électronique d'écoulement de liquide, un élément de plaquette de circuit imprimé ou un potentiomètre.

**17.** Un dispositif comprenant un boîtier contenant un mécanisme et une composition liquide auto-nivelante, caractérisé en ce que la composition liquide comprend un premier composant résineux durcissable par un rayonnement actinique et un second composant résineux durcissable à la température ambiante qui n'est pas durcissable dans des conditions d'irradiation actinique efficaces pour durcir le premier composant résineux, dans lequel une première partie de la composition liquide auto-nivelante comprenant le second composant résineux mais non le premier composant résineux est introduite dans le boîtier pour y former une première couche liquide auto-nivelante, et une seconde partie de la composition liquide auto-nivelante comprenant le premier composant résineux est introduite dans le boîtier pour former une seconde couche liquide auto-nivelante séparée et discrète, sur-jacente à la première couche liquide, dans lequel les premier et second composants résineux sont introduits en des proportions suffisantes l'un par rapport à l'autre pour que le durcissement par un rayonnement actinique du premier composant résineux immobilise la masse partiellement durcie résultante de la composition, et dans lequel le premier composant résineux est durci et le second composant résineux est non durci.

# FIG. 1

# FIG. 2

FIG. 3a

72

64

66

62

71

68

3a

64

62

FIG. 3b

70

68

3a

FIG. 4a

80  $\frac{82}{84}$  86

FIG. 4b

84

88  90

86

FIG. 5